# EUROPÄISCHE PATENTSCHRIFT

(11) **EP 3 977 586 B1**
(45) Veröffentlichungstag und Bekanntmachung des Hinweises auf die Patenterteilung: **30.09.2026**
(21) Anmeldenummer: 20725467.3
(22) Anmeldetag: 07.05.2020
(51) Int. Cl.: H02J 7/00, B60L 58/22

(54) **VERFAHREN ZUM BETREIBEN EINES ELEKTRISCHEN ENERGIESPEICHERS, ELEKTRISCHER ENERGIESPEICHER UND VORRICHTUNG**
METHOD FOR OPERATING AN ELECTRIC ENERGY STORE, ELECTRICAL ENERGY STORE AND APPARATUS
PROCÉDÉ DE FONCTIONNEMENT D'UN ACCUMULATEUR D'ÉNERGIE ÉLECTRIQUE, ACCUMULATEUR D'ÉNERGIE ÉLECTRIQUE ET DISPOSITIF

(30) Priorität: 03.06.2019 DE 102019208042
(43) Veröffentlichungstag der Anmeldung: 06.04.2022
(73) Patentinhaber: Robert Bosch GmbH, 70442 Stuttgart (DE)
(72) Erfinder: WOLL, Christoph, 70839 Gerlingen (DE); HANDTE, Gunther, 72669 Unterensingen (DE)
(86) Internationale Anmeldenummer: PCT/EP2020/062701
(87) Internationale Veröffentlichungsnummer: WO 2020/244880

(56) Entgegenhaltungen:
- EP-A1- 2 463 981

## Beschreibung

### Feld der Erfindung

Die vorliegende Erfindung bezieht sich auf ein Verfahren zum Betreiben eines elektrischen Energiespeichers, einen elektrischen Energiespeicher und eine Vorrichtung, insbesondere Fahrzeug gemäß dem Oberbegriff der unabhängigen Patentansprüche.

### Stand der Technik

Die US 2013/0169038 A1 zeigt eine Vorrichtung zur ununterbrochenen Energieversorgung eines elektrischen Fahrzeuges aus seriell verschalteten Batterien, die einen Überbrückungschalter umfasst.

Die CN 203103992 U zeigt ein Kontrollsystem für ein Batterielademanagement und Batterieentlademanagement.

Weiterhin zeigt EP 2463981 A1 ein Verfahren gemäß dem Oberbegriff von Anspruch 1.

### Offenbarung der Erfindung

Der Kern der Erfindung bei dem Verfahren zum Betreiben eines elektrischen Energiespeichers, der zumindest zwei parallel geschaltet angeordnete elektrische Energiespeichermodule und Anschlussmittel aufweist, besteht darin, dass zuerst abgefragt wird, welche elektrischen Energiespeichermodule betriebsbereit sind, wobei danach eine erste Spannung eines betriebsbereiten elektrischen Energiespeichermoduls bestimmt wird, die größer oder gleich der Spannung U aller betriebsbereiten elektrischen Energiespeichermodule ist, wobei danach diejenigen betriebsbereiten elektrischen Energiespeichermodule ausgewählt werden, deren Spannung innerhalb eines Spannungsbereichs unterhalb der ersten Spannung liegt, wobei danach die ausgewählten elektrischen Energiespeichermodule elektrisch leitend mit den Anschlussmitteln verbunden werden.

Hintergrund der Erfindung ist, dass mittels des erfindungsgemäßen Verfahrens elektrische Energiespeichermodule eines elektrischen Energiespeichers mit verschiedenen Ladezuständen und/oder verschiedenen Spannungen und/oder verschiedenen Zeitpunkten der Betriebsbereitschaft in Betrieb genommen werden können.

Vorteilhafterweise wird der elektrische Energiespeicher dabei mit einer reduzierten Leistung im Vergleich zu seiner maximalen Leistung eingeschaltet und die Leistung des elektrischen Energiespeichers während des Verfahrens nach und nach erhöht, indem weitere elektrische Energiespeichermodule zugeschaltet werden. Der Spannungsbereich umfasst die Spannung des betriebsbereiten elektrischen Energiespeichermoduls mit der maximalen ersten Spannung. Dadurch kann die Zahl der zugeschalteten elektrischen Energiespeichermodule während des Verfahrens maximiert werden, da die Spannung der elektrischen Energiespeichermodule während des Entladens abnimmt.

Weitere vorteilhafte Ausführungsformen der vorliegenden Erfindung sind Gegenstand der Unteransprüche.

Erfindungsgemäß wird, wenn nicht alle elektrischen Energiespeichermodule mit den Anschlussmitteln des elektrischen Energiespeichers verbunden wurden, zu einem späteren Zeitpunkt während des Betriebs des elektrischen Energiespeichers erneut abgefragt, welche elektrischen Energiespeichermodule betriebsbereit sind und dasjenige elektrische Energiespeichermodul (bzw. mehrere/alle Energiespeichermodule) ausgewählt, dessen Spannung innerhalb des Spannungsbereichs unterhalb einer mittleren Spannung der mit den Anschlussmitteln elektrisch verbundenen elektrischen Energiespeichermodule liegt, und mit den Anschlussmitteln elektrisch leitend verbunden. Somit können elektrische Energiespeichermodule, die zu Beginn des Verfahrens noch nicht betriebsbereit waren oder deren Spannung zu niedrig war, zu einem späteren Zeitpunkt zugeschaltet werden und so die verfügbare Leistung des elektrischen Energiespeichers während des Verfahrens erhöht werden.

Von Vorteil ist es dabei, wenn die zuvor genannten Verfahrensschritte wiederholt werden, bis alle elektrischen Energiespeichermodule mit den Anschlussmitteln elektrisch leitend verbunden sind oder der elektrische Energiespeicher abgeschaltet wird, insbesondere wobei die Verfahrensschritte zeitlich wiederkehrend, insbesondere periodisch, wiederholt werden. Dadurch können im Laufe des Verfahrens während des Betriebs des elektrischen Energiespeichers weitere elektrische Energiespeichermodule zugeschaltet werden.

Weiterhin ist es von Vorteil, wenn die Anzahl der mit den Anschlussmitteln verbundenen elektrischen Energiespeichermodule konstant bleibt, wenn die Spannung eines nicht betriebsbereiten elektrischen Energiespeichermoduls größer ist als die mittlere Spannung und kleiner ist als die Summe der mittleren Spannung und des halben Spannungsbereichs, bis dieses elektrische Energiespeichermodul betriebsbereit wird, worauf es mit den Anschlussmitteln verbunden wird, oder bis die Spannung dieses elektrischen Energiespeichermoduls größer ist als die Summe der mittleren Spannung und des halben Spannungsbereichs. Somit kann auch ein elektrisches Energiespeichermodul, das erst später betriebsbereit wird und eine hohe Spannung aufweist, noch in Betrieb genommen werden. Dabei ist es wichtig, dass ein Spannungsgrenzwert nicht überschritten wird, um die Ausgleichsströme zwischen den elektrischen Energiespeichermodulen zu begrenzen und dadurch die Schaltmittel zu schützen.

Von Vorteil ist es dabei, wenn ein elektrisches Energiespeichermodul, dessen Spannung größer ist als die mittlere Spannung, insbesondere größer ist als die Summe aus der mittleren Spannung und dem halben Spannungsbereich, nicht mit den Anschlussmitteln elektrisch leitend verbunden wird, wenn es während des Verfahrens betriebsbereit wird, insbesondere während des gesamten Verfahrens. Dadurch wird verhindert, dass die Schaltmittel beim Zuschalten dieses elektrischen Energiespeichermoduls durch zu hohe Ausgleichsströme zwischen den elektrischen Energiespeichermodulen überlastet werden.

Vorteilhafterweise werden beim Abschalten des elektrischen Energiespeichers alle elektrischen Energiespeichermodule von den Anschlussmitteln getrennt. Von Vorteil ist dabei, dass die Anschlussmittel des elektrischen Energiespeichers nach dem Abschalten des elektrischen Energiespeichers spannungsfrei sind.

Weiterhin ist es von Vorteil, wenn die Ausdehnung des Spannungsbereichs vom elektrischen Energiespeicher, insbesondere von Schaltmitteln des elektrischen Energiespeichers, abhängt und/oder während des Verfahrens konstant ist.

Vorteilhafterweise ist ein elektrisches Energiespeichermodul betriebsbereit, wenn seine Temperatur und/oder seine Spannung unterhalb eines maximalen Grenzwertes und/oder oberhalb eines minimalen Grenzwertes liegt.

Der Kern der Erfindung bei dem elektrischen Energiespeicher aufweisend Anschlussmittel und zumindest zwei elektrische Energiespeichermodule, die parallel geschaltet angeordnet sind, besteht darin, dass der elektrische Energiespeicher eingerichtet ist, mittels eines Verfahrens wie zuvor beschrieben beziehungsweise nach einem der auf das Verfahren bezogenen Ansprüche betrieben zu werden.

Hintergrund der Erfindung ist, dass die elektrischen Energiespeichermodule verschiedene Ladezustände und Zeitpunkte der Betriebsbereitschaft aufweisen können. Der elektrische Energiespeicher ist mit einer Teilmenge der elektrischen Energiespeichermodule in Betrieb nehmbar, wobei die verfügbare Leistung des elektrischen Energiespeichers erhöhbar ist.

Gemäß einer vorteilhaften Ausgestaltung weist der elektrische Energiespeicher eine Steuereinheit auf, wobei jedes elektrische Energiespeichermodul zumindest einen Sensor, insbesondere einen Spannungssensor und/oder einen Temperatursensor, und ein Schaltmittel zum elektrisch leitenden Verbinden des jeweiligen elektrischen Energiespeichermoduls mit den Anschlussmitteln des elektrischen Energiespeichers aufweist, wobei die Steuereinheit eingerichtet ist, Signale der Sensoren auszuwerten und die Schaltmittel anzusteuern. Von Vorteil ist dabei, dass eine zentrale Steuereinheit eingerichtet ist, das Verfahren zu steuern.

Vorteilhafterweise sind die elektrischen Energiespeichermodule austauschbar ausgeführt. Der elektrische Energiespeicher kann beispielsweise elektrische Energiespeichermodule aufweisen, die verschieden alt sind.

Der Kern der Erfindung bei der Vorrichtung, insbesondere dem Fahrzeug, besteht darin, dass die Vorrichtung einen elektrischen Energiespeicher wie zuvor beschrieben beziehungsweise nach einem der auf den elektrischen Energiespeicher bezogenen Ansprüche aufweist.

Hintergrund der Erfindung ist, dass die Verfügbarkeit der Vorrichtung verbessert werden kann, indem einzelne elektrische Energiespeichermodule nacheinander zugeschaltet werden können und/oder indem elektrische Energiespeichermodule austauschbar sind.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmalen der Erfindung. Insbesondere wird dabei der Fachmann auch Einzelaspekte als Verbesserungen oder Ergänzungen zu der jeweiligen Grundform der vorliegenden Erfindung hinzufügen.

### Kurze Beschreibung der Zeichnungen

Im folgenden Abschnitt wird die Erfindung anhand von Ausführungsbeispielen, aus denen sich weitere erfinderische Merkmale ergeben können, auf die die Erfindung aber in ihrem Umfang nicht beschränkt ist, erläutert. Die Ausführungsbeispiele sind in den Zeichnungen dargestellt.

Es zeigen:
- Fig. 1: eine Darstellung der Spannung U und der Betriebsbereitschaft von verschiedenen elektrischen Energiespeichermodulen (M1, M2, M3, M4, M5, M6, M7, M8, M9, M10) eines erfindungsgemäßen elektrischen Energiespeichers zu einem ersten Zeitpunkt t1,
- Fig. 2: eine Darstellung der Spannung U und der Betriebsbereitschaft der elektrischen Energiespeichermodule (M1, ... M10) des elektrischen Energiespeichers zu einem zweiten Zeitpunkt t2,
- Fig. 3: eine Darstellung der Spannung U und der Betriebsbereitschaft der verschiedenen elektrischen Energiespeichermodule (M1, ... M10) des elektrischen Energiespeichers zu einem dritten Zeitpunkt t3 und
- Fig. 4: ein schematisches Ablaufdiagramm des erfindungsgemäßen Verfahrens 100 zum Betreiben eines elektrischen Energiespeichers.

Der erfindungsgemäße elektrische Energiespeicher weist eine Mehrzahl von elektrischen Energiespeichermodulen (M1, ... M10), die parallel geschaltet angeordnet sind, zwei Anschlussmittel und eine Steuereinheit auf. Jedes elektrische Energiespeichermodul (M1, ... M10) weist zumindest einen Sensor, insbesondere einen Spannungssensor und/oder einen Temperatursensor, und Schaltmittel zum elektrisch leitenden Verbinden des jeweiligen elektrischen Energiespeichermoduls (M1, ... M10) mit den Anschlussmitteln des elektrischen Energiespeichers auf. Die Steuereinheit ist eingerichtet, Signale der Sensoren auszuwerten und die Schaltmittel anzusteuern.

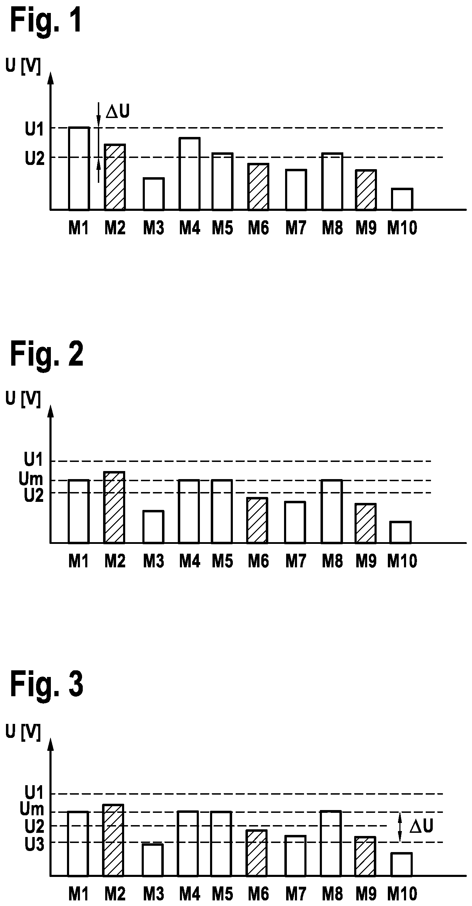

In Fig. 1 sind die Spannungen der verschiedenen elektrischen Energiespeichermodule (M1, ... M10), in diesem Ausführungsbeispiel zehn elektrische Energiespeichermodule (M1, ... M10), zu einem ersten Zeitpunkt t1 dargestellt. Dabei ist die Spannung U eines betriebsbereiten elektrischen Energiespeichermoduls (M1, ... M10) mittels eines weißen Balkens dargestellt und die Spannung U eines nicht betriebsbereiten elektrischen Energiespeichermoduls (M1, ... M10) ist mittels eines schraffierten Balkens dargestellt.

Der erste Zeitpunkt t1 ist zeitlich vor Inbetriebnahme des elektrischen Energiespeichers.

Zu dem ersten Zeitpunkt t1 weisen die elektrischen Energiespeichermodule (M1, ... M10) verschiedene Spannungen auf. Sieben elektrische Energiespeichermodule (M1, M3, M4, M5, M7, M8, M10) sind betriebsbereit. Drei weitere elektrische Energiespeichermodule (M2, M6, M9) sind nicht betriebsbereit.

Ein erstes elektrisches Energiespeichermodul M1 weist eine erste Spannung U1 auf, die größer ist als die Spannungen der anderen elektrischen Energiespeichermodule (M2, ... M10) des elektrischen Energiespeichers. Der elektrische Energiespeicher weist einen Spannungsbereich ΔU auf, innerhalb dessen elektrische Energiespeichermodule (M1, ... M10) mit verschiedenen Spannungen U in Betrieb genommen werden können. Bevorzugt werden diejenigen elektrischen Energiespeichermodule (M1, ... M10) zuerst in Betrieb genommen, die betriebsbereit sind und die höchsten Spannungen aufweisen. Das sind die betriebsbereiten elektrischen Energiespeichermodule (M1, ... M10), deren Spannung zwischen der ersten Spannung U1 und einer zweiten Spannung U2 liegt. Dabei begrenzt die erste Spannung U1 den Spannungsbereich ΔU nach oben und die zweite Spannung U2 begrenzt den Spannungsbereich ΔU nach unten. Die zweite Spannung U2 ist also um ΔU kleiner als die erste Spannung U1.

Dabei ist die Ausdehnung des Spannungsbereichs ΔU abhängig von dem elektrischen Energiespeicher, insbesondere von den Schaltmitteln des elektrischen Energiespeichers, und während des Verfahrens unveränderlich. Sie richtet sich nach der maximal erlaubten Stromstärke an den Schaltmitteln unter Last, die Ausgleichsströme zwischen den zusammengeschalteten elektrischen Energiespeichermodulen aufweisen. Der Spannungsbereich ΔU hat eine Ausdehnung, die kleiner ist als 5 V, insbesondere kleiner als 3 V, vorzugsweise ungefähr 1 V beträgt. Dadurch werden die Ausgleichsströme zwischen den elektrischen Energiespeichermodulen (M1, ... M10) auf weniger als 25 A begrenzt. Diese Werte entsprechen einer Varianz des Ladezustands von 5 % zwischen den elektrischen Energiespeichermodulen.

In diesem Ausführungsbeispiel weisen das erste elektrische Energiespeichermodul M1, das vierte elektrische Energiespeichermodul M4, das fünfte elektrische Energiespeichermodul M5 und das achte elektrische Energiespeichermodul M8 jeweils eine Spannung U auf, die innerhalb des Spannungsbereichs ΔU zwischen der ersten Spannung U1 und der zweiten Spannung U2 liegt, und betriebsbereit sind. Die Spannung U des zweiten elektrischen Energiespeichermoduls M2 liegt zwar innerhalb des Spannungsbereichs ΔU, aber das zweite elektrische Energiespeichermodul M2 ist nicht betriebsbereit. Die Spannungen U der übrigen elektrischen Energiespeichermodule (M3, M6, M7, M9, M10) liegen unterhalb der zweiten Spannung U2.

In Fig. 2 sind die Spannungen der verschiedenen elektrischen Energiespeichermodule (M1, ... M10) zu einem zweiten Zeitpunkt t2 dargestellt. Dabei ist die Spannung eines betriebsbereiten elektrischen Energiespeichermoduls (M1, ... M10) mittels eines weißen Balkens dargestellt und die Spannung eines nicht betriebsbereiten elektrischen Energiespeichermoduls (M1, ... M10) ist mittels eines schraffierten Balkens dargestellt.

Der zweite Zeitpunkt t2 ist zeitlich nach dem ersten Zeitpunkt t1 und kurz nach der Inbetriebnahme des elektrischen Energiespeichers.

Zum zweiten Zeitpunkt t2 sind diejenigen elektrischen Energiespeichermodule (M1, ... M10) miteinander und mit den Anschlussmitteln und/oder einer Vorrichtung elektrisch leitend verbunden, die zum ersten Zeitpunkt t1 betriebsbereit waren und deren Spannung zwischen der ersten Spannung U1 und der zweiten Spannung U2 lag. Das sind das erste elektrische Energiespeichermodul M1, das vierte elektrische Energiespeichermodul M4, das fünfte elektrische Energiespeichermodul M5 und das achte elektrische Energiespeichermodul M8. Beim Verbinden dieser elektrischen Energiespeichermodule (M1, M4, M5, M8) gleicht sich die Spannung dieser elektrischen Energiespeichermodule aneinander an, so dass diese elektrischen Energiespeichermodule (M1, M4, M5, M8) jeweils eine mittlere Spannung Um aufweisen.

In Fig. 3 sind die Spannungen der verschiedenen elektrischen Energiespeichermodule (M1, ... M10) zu einem dritten Zeitpunkt t3 dargestellt. Dabei ist die Spannung eines betriebsbereiten elektrischen Energiespeichermoduls (M1, ... M10) mittels eines weißen Balkens dargestellt und die Spannung eines nicht betriebsbereiten elektrischen Energiespeichermoduls (M1, ... M10) ist mittels eines schraffierten Balkens dargestellt.

Der dritte Zeitpunkt t3 ist zeitlich nach dem ersten Zeitpunkt t1 und nach dem zweiten Zeitpunkt t2.

Zum dritten Zeitpunkt t3 sind diejenigen elektrischen Energiespeichermodule (M1, M4, M5, M8) miteinander und mit den Anschlussmitteln und/oder der Vorrichtung elektrisch leitend verbunden, die zum zweiten Zeitpunkt t2 miteinander und mit den Anschlussmitteln und/oder der Vorrichtung elektrisch leitend verbunden waren. Das sind das erste elektrische Energiespeichermodul M1, das vierte elektrische Energiespeichermodul M4, das fünfte elektrische Energiespeichermodul M5 und das achte elektrische Energiespeichermodul M8.

Das elektrische Energiespeichermodul (M1, ... M10) mit der höchsten Spannung U zum dritten Zeitpunkt t3 ist das zweite Energiespeichermodul M2, allerdings ist das zweite Energiespeichermodul auch zum dritten Zeitpunkt t3 nicht betriebsbereit.

Das betriebsbereite elektrische Energiespeichermodul (M1, ... M10) mit der höchsten Spannung sind das erste, vierte, fünfte und achte elektrische Energiespeichermodul (M1, M4, M5, M8), die alle die mittlere Spannung Um aufweisen.

Der Spannungsbereich ΔU erstreckt sich zum dritten Zeitpunkt t3 nicht mehr von der ersten Spannung U1 bis zur zweiten Spannung U2, sondern von der mittleren Spannung Um zu einer dritten Spannung U3, die kleiner ist als die zweite Spannung U2. Die dritte Spannung U3 ist dabei um ΔU kleiner als die mittlere Spannung Um.

Alle betriebsbereiten elektrischen Energiespeichermodule (M1, ... M10), deren Spannung U zwischen der mittleren Spannung Um und der dritten Spannung U3 liegt, können zum dritten Zeitpunkt t3 in Betrieb genommen werden. Das ist neben dem ersten elektrischen Energiespeichermodul M1, dem vierten elektrischen Energiespeichermodul M4, dem fünften elektrischen Energiespeichermodul M5 und dem achten elektrischen Energiespeichermodul M8 das siebte elektrische Energiespeichermodul M7.

Die Spannungen U des sechsten elektrischen Energiespeichermoduls M6 und des neunten elektrischen Energiespeichermoduls M9 liegen zwar ebenfalls im Spannungsbereich ΔU zwischen der mittleren Spannung Um und der dritten Spannung U3, allerdings sind das sechste elektrische Energiespeichermodul M6 und das neunte elektrische Energiespeichermodul M9 nicht betriebsbereit.

Sobald ein elektrisches Energiespeichermodul (M1, ... M10), dessen Spannung U innerhalb des Spannungsbereichs ΔU liegt, betriebsbereit wird, kann dieses ebenfalls eingeschaltet werden. Sollte ein elektrisches Energiespeichermodul (M1, ... M10), dessen Spannung oberhalb der mittleren Spannung Um, insbesondere oberhalb der Summe aus der mittleren Spannung Um und des halben Spannungsbereichs ΔU, liegt, betriebsbereit werden, so kann dieses erst nach dem nächsten Start des elektrischen Energiespeichers eingeschaltet werden.

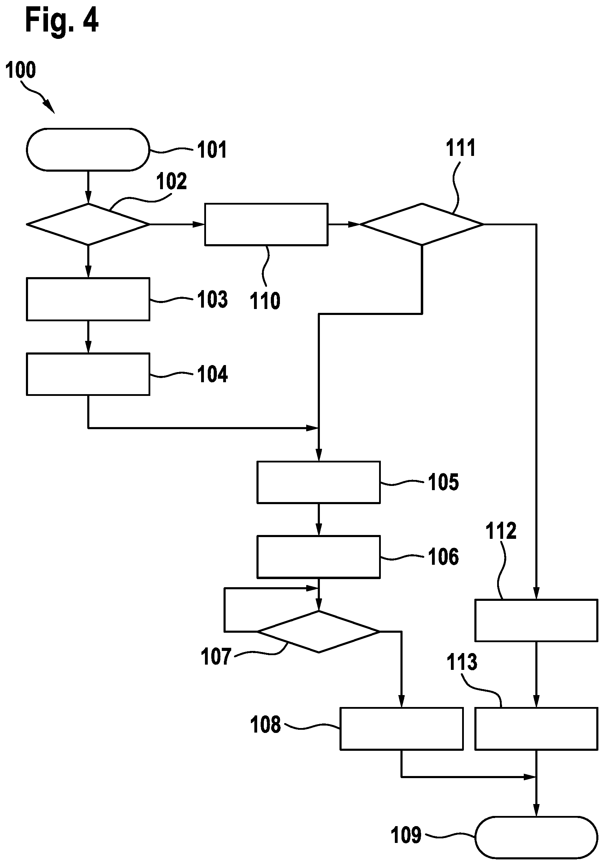

In Fig. 4 ist ein Ablaufdiagramm des erfindungsgemäßen Verfahrens 100 zum Betreiben eines elektrischen Energiespeichers dargestellt. Das Verfahren 100 zum Betreiben eines elektrischen Energiespeichers weist die folgenden Verfahrensschritte auf:
In einem ersten Verfahrensschritt 101 wird der elektrische Energiespeicher initialisiert. Dabei werden jeweilige Betriebsparameter, insbesondere eine jeweilige Spannung U und/oder eine jeweilige Temperatur und/oder der jeweilige Ladezustand und gegebenenfalls weitere Parameter, der jeweiligen elektrischen Energiespeichermodule (M1, ... M10) erfasst.

In einem zweiten Verfahrensschritt 102 nach dem ersten Verfahrensschritt 101 wird abgefragt, ob alle elektrischen Energiespeichermodule (M1, ... M10) des elektrischen Energiespeichers betriebsbereit sind.

Wenn nicht alle elektrischen Energiespeichermodule (M1, ... M10) betriebsbereit sind, werden in einem dritten Verfahrensschritt 103 nach dem zweiten Verfahrensschritt 102 die betriebsbereiten elektrischen Energiespeichermodule (M1, ... M10) ausgewählt.

In einem vierten Verfahrensschritt 104 nach dem dritten Verfahrensschritt 103 wird von den betriebsbereiten elektrischen Energiespeichermodulen (M1, ... M10) dasjenige elektrische Energiespeichermodul (M1, ... M10) mit einer maximalen ersten Spannung U1 ausgewählt. Dabei ist die maximale erste Spannung U1 größer als alle anderen Spannungen U der betriebsbereiten elektrischen Energiespeichermodule (M1, ... M10). Danach werden diejenigen betriebsbereiten elektrischen Energiespeichermodule (M1, ... M10) ausgewählt, deren jeweilige Spannung U innerhalb eines Spannungsbereichs ΔU unterhalb der ersten Spannung U1 liegt.

In einem fünften Verfahrensschritt 105 nach dem vierten Verfahrensschritt 104 oder dem elften Verfahrensschritt 111 werden die im vierten Verfahrensschritt 104 oder im zehnten Verfahrensschritt 110 ausgewählten elektrischen Energiespeichermodule (M1, ... M10) elektrisch leitend miteinander und mit den Anschlussmitteln und/oder einer Vorrichtung verbunden.

In einem sechsten Verfahrensschritt 106 nach dem fünften Verfahrensschritt 105 wird der elektrische Energiespeicher und/oder die Vorrichtung mit den im vierten Verfahrensschritt 104 oder im zehnten Verfahrensschritt 110 ausgewählten elektrischen Energiespeichermodulen (M1, ... M10) gestartet. Dabei ist die Leistung des elektrischen Energiespeichers im Vergleich zu einem Betrieb mit allen elektrischen Energiespeichermodulen (M1, ... M10) reduziert. Danach gleichen sich die Spannungen U der miteinander verbundenen elektrischen Energiespeichermodule (M1, ... M10) aneinander an und es stellt sich eine mittlere Spannung Um bei allen miteinander elektrisch leitend verbundenen elektrischen Energiespeichermodulen (M1, ... M10) ein.

In einem siebten Verfahrensschritt 107 nach dem sechsten Verfahrensschritt 106 wird abgefragt, ob weitere elektrische Energiespeichermodule (M1, ... M10) betriebsbereit sind und eine Spannung U aufweisen, die innerhalb eines Spannungsbereichs ΔU unterhalb der mittleren Spannung Um der ausgewählten elektrischen Energiespeichermodule (M1, ... M10) liegt, und gegebenenfalls dieses elektrische Energiespeichermodul (M1, ... M10) ausgewählt.

Falls im siebten Verfahrensschritt 107 kein elektrisches Energiespeichermodul (M1, ... M10) ausgewählt wurde, wird der siebte Verfahrensschritt 107 zeitlich wiederkehrend, insbesondere periodisch, wiederholt.

Falls im siebten Verfahrensschritt 107 ein elektrisches Energiespeichermodul (M1, ... M10) ausgewählt wurde, wird in einem achten Verfahrensschritt 108 dieses elektrische Energiespeichermodul (M1, ... M10) mit den bereits miteinander elektrisch leitend verbundenen elektrischen Energiespeichermodulen (M1, ... M10) und den Anschlussmitteln und/oder der Vorrichtung elektrisch leitend verbunden.

Der siebte Verfahrensschritt 107 und der achte Verfahrensschritt 108 werden solange wiederholt, bis alle elektrischen Energiespeichermodule (M1, ... M10) miteinander und mit den Anschlussmitteln und/oder mit der Vorrichtung elektrisch leitend verbunden sind oder das Verfahren 100 in einem neunten Verfahrensschritt 109 beendet wird und der elektrische Energiespeicher und/oder die Vorrichtung abgeschaltet wird.

Wenn im zweiten Verfahrensschritt 102 alle elektrischen Energiespeichermodule (M1, ... M10) betriebsbereit sind, wird in einem zehnten Verfahrensschritt 110 nach dem zweiten Verfahrensschritt 102 von den elektrischen Energiespeichermodulen (M1, ... M10) dasjenige elektrische Energiespeichermodul (M1, ... M10) mit einer maximalen ersten Spannung U1 ausgewählt. Dabei ist die maximale erste Spannung U1 größer als alle anderen Spannungen U der elektrischen Energiespeichermodule (M1, ... M10). Danach werden diejenigen elektrischen Energiespeichermodule (M1, ... M10) ausgewählt, deren jeweilige Spannung U innerhalb eines Spannungsbereichs ΔU unterhalb der ersten Spannung U1 liegt.

In einem elften Verfahrensschritt 111 nach dem zehnten Verfahrensschritt 110 wird abgefragt, ob alle elektrischen Energiespeichermodule (M1, ... M10) im zehnten Verfahrensschritt 110 ausgewählt wurden.

Wenn nicht alle elektrischen Energiespeichermodule (M1, ... M10) im zehnten Verfahrensschritt 110 ausgewählt wurden, wird das Verfahren nach dem elften Verfahrensschritt 111 mit dem fünften Verfahrensschritt 105 fortgesetzt.

Wenn im zehnten Verfahrensschritt 110 alle elektrischen Energiespeichermodule (M1, ... M10) des elektrischen Energiespeichers ausgewählt wurden, werden in einem zwölften Verfahrensschritt alle elektrischen Energiespeichermodule (M1, ... M10) miteinander und mit den Anschlussmitteln und/oder der Vorrichtung elektrisch leitend verbunden.

In einem dreizehnten Verfahrensschritt 113 nach dem zwölften Verfahrensschritt 112 wird der elektrische Energiespeicher und/oder die Vorrichtung mit allen elektrischen Energiespeichermodulen (M1, ... M10) gestartet.

Nach dem dreizehnten Verfahrensschritt 113 wird das Verfahren im neunten Verfahrensschritt 109 beendet und der elektrische Energiespeicher und/oder die Vorrichtung abgeschaltet.

Vorzugsweise wird die jeweilige elektrisch leitende Verbindung zwischen dem jeweiligen elektrischen Energiespeichermodul (M1, ... M10) und den Anschlussmitteln und/oder der Vorrichtung nach dem neunten Verfahrensschritt getrennt.

Unter einem elektrischen Energiespeicher wird hierbei ein wiederaufladbarer Energiespeicher verstanden, insbesondere aufweisend eine elektrochemische Energiespeicherzelle und/oder ein Energiespeichermodul aufweisend zumindest eine elektrochemische Energiespeicherzelle und/oder ein Energiespeicherpack aufweisend zumindest ein Energiespeichermodul. Die Energiespeicherzelle ist als lithiumbasierte Batteriezelle, insbesondere Lithium-Ionen-Batteriezelle, ausführbar. Alternativ ist die Energiespeicherzelle als Lithium-Polymer-Batteriezelle oder Nickel-Metallhydrid-Batteriezelle oder Blei-Säure-Batteriezelle oder Lithium-Luft-Batteriezelle oder Lithium-Schwefel-Batteriezelle ausgeführt.

## Patentansprüche

1. Verfahren (100) zum Entladen eines elektrischen Energiespeichers, der zumindest zwei parallel geschaltet angeordnete elektrische Energiespeichermodule (M1, M2, M3, M4, M5, M6, M7, M8, M9, M10) und Anschlussmittel aufweist,
wobei zuerst abgefragt wird, welche elektrischen Energiespeichermodule (M1, M2, M3, M4, M5, M6, M7, M8, M9, M10) betriebsbereit sind,
wobei danach eine erste Spannung (U1) eines betriebsbereiten elektrischen Energiespeichermoduls (M1, M2, M3, M4, M5, M6, M7, M8, M9, M10) bestimmt wird, die größer als die jeweilige Spannung (U) aller betriebsbereiten elektrischen Energiespeichermodule (M1, M2, M3, M4, M5, M6, M7, M8, M9, M10) ist,
wobei danach diejenigen betriebsbereiten elektrischen Energiespeichermodule (M1, M2, M3, M4, M5, M6, M7, M8, M9, M10) ausgewählt werden, deren Spannung innerhalb eines Spannungsbereichs (ΔU) unterhalb der ersten Spannung (U1) liegt,
wobei danach die ausgewählten elektrischen Energiespeichermodule (M1, M2, M3, M4, M5, M6, M7, M8, M9, M10) elektrisch leitend mit den Anschlussmitteln verbunden werden, sodass Ausgleichsströme zwischen den Energiespeichermodulen fließen,
**dadurch gekennzeichnet, dass**
wenn nicht alle elektrischen Energiespeichermodule (M1, M2, M3, M4, M5, M6, M7, M8, M9, M10) mit den Anschlussmitteln des elektrischen Energiespeichers verbunden wurden, zu einem späteren Zeitpunkt während des Betriebs des elektrischen Energiespeichers erneut abgefragt wird, welche elektrischen Energiespeichermodule (M1, M2, M3, M4, M5, M6, M7, M8, M9, M10) betriebsbereit sind und diejenigen elektrischen Energiespeichermodule (M1, M2, M3, M4, M5, M6, M7, M8, M9, M10) ausgewählt werden, deren Spannung (U) innerhalb des Spannungsbereichs (ΔU) unterhalb einer mittleren Spannung (Um) der mit den Anschlussmitteln elektrisch verbundenen elektrischen Energiespeichermodule (M1, M2, M3, M4, M5, M6, M7, M8, M9, M10) liegen, und mit den Anschlussmitteln elektrisch leitend verbunden werden.

2. Verfahren (100) zum Betreiben eines elektrischen Energiespeichers nach Anspruch 1,
**dadurch gekennzeichnet, dass**
die Verfahrensschritte gemäß Anspruch 2 wiederholt werden, bis alle elektrischen Energiespeichermodule (M1, M2, M3, M4, M5, M6, M7, M8, M9, M10) mit den Anschlussmitteln elektrisch leitend verbunden sind oder der elektrische Energiespeicher abgeschaltet wird, insbesondere wobei die Verfahrensschritte zeitlich wiederkehrend, insbesondere periodisch, wiederholt werden.

3. Verfahren (100) zum Betreiben eines elektrischen Energiespeichers nach einem der Ansprüche 1 oder 2,
**dadurch gekennzeichnet, dass**
wenn die Spannung eines nicht betriebsbereiten elektrischen Energiespeichermoduls (M1, M2, M3, M4, M5, M6, M7, M8, M9, M10) größer ist als die mittlere Spannung (Um) und kleiner ist als die Summe der mittleren Spannung (Um) und des halben Spannungsbereichs (ΔU), die Anzahl der mit den Anschlussmitteln verbundenen elektrischen Energiespeichermodule (M1, M2, M3, M4, M5, M6, M7, M8, M9, M10) konstant bleibt, bis dieses elektrische Energiespeichermodul (M1, M2, M3, M4, M5, M6, M7, M8, M9, M10) betriebsbereit wird, worauf es mit den Anschlussmitteln verbunden wird, oder bis die Spannung dieses elektrischen Energiespeichermoduls (M1, M2, M3, M4, M5, M6, M7, M8, M9, M10) größer ist als die Summe der mittleren Spannung (Um) und des halben Spannungsbereichs (ΔU).

4. Verfahren (100) zum Betreiben eines elektrischen Energiespeichers nach einem der Ansprüche 1 bis 3,
**dadurch gekennzeichnet, dass**
wenn ein elektrisches Energiespeichermodul (M1, M2, M3, M4, M5, M6, M7, M8, M9, M10), dessen Spannung (U) größer ist als die mittlere Spannung (Um), insbesondere größer als die Summe der mittleren Spannung (Um) und des halben Spannungsbereichs (ΔU), während des Verfahrens (100) betriebsbereit wird, dieses elektrische Energiespeichermodul (M1, M2, M3, M4, M5, M6, M7, M8, M9, M10) nicht mit den Anschlussmitteln elektrisch leitend verbunden wird, insbesondere während des gesamten Verfahrens (100).

5. Verfahren (100) zum Betreiben eines elektrischen Energiespeichers nach einem der vorhergehenden Ansprüche,
**dadurch gekennzeichnet, dass**
beim Abschalten des elektrischen Energiespeichers alle elektrischen Energiespeichermodule (M1, M2, M3, M4, M5, M6, M7, M8, M9, M10) von den Anschlussmitteln getrennt werden.

6. Verfahren (100) zum Betreiben eines elektrischen Energiespeichers nach einem der vorhergehenden Ansprüche,
**dadurch gekennzeichnet, dass**
die Ausdehnung des Spannungsbereichs (ΔU) vom elektrischen Energiespeicher, insbesondere von Schaltmitteln des elektrischen Energiespeichers, abhängt und/oder während des Verfahrens (100) konstant ist.

7. Verfahren (100) zum Betreiben eines elektrischen Energiespeichers nach einem der vorhergehenden Ansprüche,
**dadurch gekennzeichnet, dass**
ein elektrisches Energiespeichermodul (M1, M2, M3, M4, M5, M6, M7, M8, M9, M10) betriebsbereit ist, wenn seine Temperatur und/oder seine Spannung (U) und/oder sein Ladezustand unterhalb eines maximalen Grenzwertes und/oder oberhalb eines minimalen Grenzwertes liegt.

8. Elektrischer Energiespeicher aufweisend Anschlussmittel und zumindest zwei elektrische Energiespeichermodule (M1, M2, M3, M4, M5, M6, M7, M8, M9, M10), die parallel geschaltet angeordnet sind,
**dadurch gekennzeichnet, dass**
der elektrische Energiespeicher eingerichtet ist, mittels eines Verfahrens nach einem der vorhergehenden Ansprüche betrieben zu werden.

9. Elektrischer Energiespeicher nach Anspruch 8,
**dadurch gekennzeichnet, dass**
der elektrische Energiespeicher eine Steuereinheit aufweist,
wobei jedes elektrische Energiespeichermodul (M1, M2, M3, M4, M5, M6, M7, M8, M9, M10) zumindest einen Sensor, insbesondere einen Spannungssensor und/oder einen Temperatursensor, und ein Schaltmittel zum elektrisch leitenden Verbinden des jeweiligen elektrischen Energiespeichermoduls (M1, M2, M3, M4, M5, M6, M7, M8, M9, M10) mit den Anschlussmitteln des elektrischen Energiespeichers aufweist, wobei die Steuereinheit eingerichtet ist, Signale der Sensoren auszuwerten und die Schaltmittel anzusteuern.

10. Vorrichtung, insbesondere Fahrzeug,
**dadurch gekennzeichnet, dass**
die Vorrichtung einen elektrischen Energiespeicher nach einem der Ansprüche 8 oder 9 aufweist.

## Claims

1. Method (100) for discharging an electrical energy store having at least two electrical energy storage modules (M1, M2, M3, M4, M5, M6, M7, M8, M9, M10) arranged so as to be connected in parallel and connection means, wherein it is first queried which electrical energy storage modules (M1, M2, M3, M4, M5, M6, M7, M8, M9, M10) are operational,
wherein a first voltage (U1) of an operational electrical energy storage module (M1, M2, M3, M4, M5, M6, M7, M8, M9, M10) that is greater than the respective voltage (U) of all operational electrical energy storage modules (M1, M2, M3, M4, M5, M6, M7, M8, M9, M10) is then determined,
wherein those operational electrical energy storage modules (M1, M2, M3, M4, M5, M6, M7, M8, M9, M10) whose voltage is within a voltage range (ΔU) below the first voltage (U1) are then selected,
wherein the selected electrical energy storage modules (M1, M2, M3, M4, M5, M6, M7, M8, M9, M10) are then electrically conductively connected to the connection means such that compensation currents flow between the energy storage modules,
**characterized in that**
if not all electrical energy storage modules (M1, M2, M3, M4, M5, M6, M7, M8, M9, M10) have been connected to the connection means of the electrical energy store, it is queried again at a later time during the operation of the electrical energy store which electrical energy storage modules (M1, M2, M3, M4, M5, M6, M7, M8, M9, M10) are operational and those electrical energy storage modules (M1, M2, M3, M4, M5, M6, M7, M8, M9, M10) whose voltage (U) is within the voltage range (ΔU) below an average voltage (Um) of the electrical energy storage modules (M1, M2, M3, M4, M5, M6, M7, M8, M9, M10) electrically connected to the connection means are selected and are electrically conductively connected to the connection means.

2. Method (100) for operating an electrical energy store according to Claim 1,
**characterized in that**
the method steps according to Claim 2 are repeated until all electrical energy storage modules (M1, M2, M3, M4, M5, M6, M7, M8, M9, M10) are electrically conductively connected to the connection means or the electrical energy store is switched off, in particular wherein the method steps are repeated recurrently in time, in particular periodically.

3. Method (100) for operating an electrical energy store according to either of Claims 1 and 2,
**characterized in that**
if the voltage of a non-operational electrical energy storage module (M1, M2, M3, M4, M5, M6, M7, M8, M9, M10) is greater than the average voltage (Um) and less than the sum of the average voltage (Um) and half the voltage range (ΔU), the number of electrical energy storage modules (M1, M2, M3, M4, M5, M6, M7, M8, M9, M10) connected to the connection means remains constant, until this electrical energy storage module (M1, M2, M3, M4, M5, M6, M7, M8, M9, M10) becomes operational, whereupon it is connected to the connection means, or until the voltage of this electrical energy storage module (M1, M2, M3, M4, M5, M6, M7, M8, M9, M10) is greater than the sum of the average voltage (Um) and half the voltage range (ΔU).

4. Method (100) for operating an electrical energy store according to one of Claims 1 to 3,
**characterized in that**
if an electrical energy storage module (M1, M2, M3, M4, M5, M6, M7, M8, M9, M10) whose voltage (U) is greater than the average voltage (Um), in particular greater than the sum of the average voltage (Um) and half the voltage range (ΔU), becomes operational during the method (100), this electrical energy storage module (M1, M2, M3, M4, M5, M6, M7, M8, M9, M10) is not electrically conductively connected to the connection means, in particular during the entire method (100).

5. Method (100) for operating an electrical energy store according to one of the preceding claims,
**characterized in that**
when the electrical energy store is switched off, all electrical energy storage modules (M1, M2, M3, M4, M5, M6, M7, M8, M9, M10) are disconnected from the connection means.

6. Method (100) for operating an electrical energy store according to one of the preceding claims,
**characterized in that**
the extent of the voltage range (ΔU) depends on the electrical energy store, in particular on switching means of the electrical energy store, and/or is constant during the method (100).

7. Method (100) for operating an electrical energy store according to one of the preceding claims,
**characterized in that**
an electrical energy storage module (M1, M2, M3, M4, M5, M6, M7, M8, M9, M10) is operational if its temperature and/or its voltage (U) and/or its state of charge is below a maximum limit value and/or above a minimum limit value.

8. Electrical energy store having connection means and at least two electrical energy storage modules (M1, M2, M3, M4, M5, M6, M7, M8, M9, M10) which are arranged so as to be connected in parallel,
**characterized in that**
the electrical energy store is configured to be operated by means of a method according to one of the preceding claims.

9. Electrical energy store according to Claim 8,
**characterized in that**
the electrical energy store has a control unit,
wherein each electrical energy storage module (M1, M2, M3, M4, M5, M6, M7, M8, M9, M10) has at least one sensor, in particular a voltage sensor and/or a temperature sensor, and a switching means for electrically conductively connecting the respective electrical energy storage module (M1, M2, M3, M4, M5, M6, M7, M8, M9, M10) to the connection means of the electrical energy store,
wherein the control unit is configured to evaluate signals from the sensors and to control the switching means.

10. Apparatus, in particular vehicle,
**characterized in that**
the apparatus has an electrical energy store according to either of Claims 8 and 9.

## Revendications

1. Procédé (100) de décharge d'un accumulateur d'énergie électrique présentant au moins deux modules d'accumulateur d'énergie électrique connectés en parallèle (M1, M2, M3, M4, M5, M6, M7, M8, M9, M10) et des moyens de raccordement,
une demande selon laquelle quels modules d'accumulateur d'énergie électrique (M1, M2, M3, M4, M5, M6, M7, M8, M9, M10) sont prêts au fonctionnement étant effectuée en premier lieu,
une première tension (U1) d'un module d'accumulateur d'énergie électrique prêt au fonctionnement (M1, M2, M3, M4, M5, M6, M7, M8, M9, M10), qui est supérieure à la tension (U) respective de tous les modules d'accumulateur d'énergie électrique prêts au fonctionnement (M1, M2, M3, M4, M5, M6, M7, M8, M9, M10), étant déterminée ensuite,
les modules d'accumulateur d'énergie électrique prêts au fonctionnement (M1, M2, M3, M4, M5, M6, M7, M8, M9, M10) dont la tension à l'intérieur de la plage de tension (ΔU) se situe en dessous de la première tension (U1) étant ensuite sélectionnés,
les modules d'accumulateur d'énergie électrique sélectionnés (M1, M2, M3, M4, M5, M6, M7, M8, M9, M10) étant ensuite reliés aux moyens de raccordement de façon électroconductrice, de sorte que des courants d'équilibrage circulent entre les modules d'accumulateur d'énergie,
**caractérisé en ce que**
lorsque tous les modules d'accumulateur d'énergie électrique (M1, M2, M3, M4, M5, M6, M7, M8, M9, M10) n'ont pas été reliés aux moyens de raccordement de l'accumulateur d'énergie électrique, il est à nouveau demandé, à un moment ultérieur pendant le fonctionnement de l'accumulateur d'énergie électrique, quels modules d'accumulateur d'énergie électrique (M1, M2, M3, M4, M5, M6, M7, M8, M9, M10) sont prêts au fonctionnement, et les modules d'accumulateur d'énergie électrique (M1, M2, M3, M4, M5, M6, M7, M8, M9, M10) dont la tension (U) à l'intérieur de la plage de tension (ΔU) se situe en dessous d'une tension moyenne (Um) des modules d'accumulateur d'énergie électrique reliés électriquement aux moyens de raccordement (M1, M2, M3, M4, M5, M6, M7, M8, M9, M10) sont sélectionnés, et sont reliés aux moyens de raccordement de façon électroconductrice.

2. Procédé (100) de fonctionnement d'un accumulateur d'énergie électrique selon la revendication 1,
**caractérisé en ce que**
les étapes du procédé selon la revendication 2 sont répétées jusqu'à ce que tous les modules d'accumulateur d'énergie électrique (M1, M2, M3, M4, M5, M6, M7, M8, M9, M10) soient reliés de façon électroconductrice aux moyens de raccordement ou que l'accumulateur d'énergie électrique soit mis à l'arrêt, les étapes de procédé étant notamment répétées de manière temporellement récurrente, notamment de façon périodique.

3. Procédé (100) de fonctionnement d'un accumulateur d'énergie électrique selon l'une quelconque des revendications 1 ou 2,
**caractérisé en ce que**
lorsque la tension d'un module d'accumulateur d'énergie électrique non prêt au fonctionnement (M1, M2, M3, M4, M5, M6, M7, M8, M9, M10) est supérieure à la tension moyenne (Um) et inférieure à la somme de la tension moyenne (Um) et de la moitié de la plage de tension (ΔU), le nombre de modules d'accumulateur d'énergie électrique reliés aux moyens de raccordement (M1, M2, M3, M4, M5, M6, M7, M8, M9, M10) reste constant jusqu'à ce que ce module d'accumulateur d'énergie électrique (M1, M2, M3, M4, M5, M6, M7, M8, M9, M10) devienne prêt au fonctionnement, sur quoi il est relié aux moyens de raccordement, ou jusqu'à ce que la tension de ce module d'accumulateur d'énergie électrique (M1, M2, M3, M4, M5, M6, M7, M8, M9, M10) soit supérieure à la somme de la tension moyenne (Um) et de la moitié de la plage de tension (ΔU).

4. Procédé (100) de fonctionnement d'un accumulateur d'énergie électrique selon l'une quelconque des revendications 1 à 3,
**caractérisé en ce que**
lorsqu'un module d'accumulateur d'énergie électrique (M1, M2, M3, M4, M5, M6, M7, M8, M9, M10) dont la tension (U) est supérieure à la tension moyenne (Um), notamment supérieure à la somme de la tension moyenne (Um) et de la moitié de la plage de tension (ΔU), devient prêt au fonctionnement pendant le procédé (100), ce module d'accumulateur d'énergie électrique (M1, M2, M3, M4, M5, M6, M7, M8, M9, M10) n'est pas relié de façon électroconductrice aux moyens de raccordement, en particulier pendant l'ensemble du procédé (100).

5. Procédé (100) de fonctionnement d'un accumulateur d'énergie électrique selon l'une quelconque des revendications précédentes,
**caractérisé en ce que**
lors de la mise à l'arrêt de l'accumulateur d'énergie électrique, tous les modules d'accumulateur d'énergie électrique (M1, M2, M3, M4, M5, M6, M7, M8, M9, M10) sont séparés des moyens de raccordement.

6. Procédé (100) de fonctionnement d'un accumulateur d'énergie électrique selon l'une quelconque des revendications précédentes,
**caractérisé en ce que**
l'étendue de la plage de tension (ΔU) dépend de l'accumulateur d'énergie électrique, notamment de moyens de commutation de l'accumulateur d'énergie électrique, et/ou est constante pendant le procédé (100).

7. Procédé (100) de fonctionnement d'un accumulateur d'énergie électrique selon l'une quelconque des revendications précédentes,
**caractérisé en ce que**
un module d'accumulateur d'énergie électrique (M1, M2, M3, M4, M5, M6, M7, M8, M9, M10) est prêt au fonctionnement lorsque sa température et/ou sa tension (U) et/ou son état de charge se situent en dessous d'une valeur limite maximale et/ou au-dessus d'une valeur limite minimale.

8. Accumulateur d'énergie électrique présentant des moyens de raccordement et au moins deux modules d'accumulateur d'énergie électrique (M1, M2, M3, M4, M5, M6, M7, M8, M9, M10), qui sont connectés en parallèle,
**caractérisé en ce que**
l'accumulateur d'énergie électrique est conçu pour être mis en fonctionnement au moyen d'un procédé selon l'une quelconque des revendications précédentes.

9. Accumulateur d'énergie électrique selon la revendication 8,
**caractérisé en ce que**
l'accumulateur d'énergie électrique présente une unité de commande, chaque module d'accumulateur d'énergie électrique (M1, M2, M3, M4, M5, M6, M7, M8, M9, M10) présentant au moins un capteur, en particulier un capteur de tension et/ou un capteur de température, et un moyen de commutation pour relier de façon électroconductrice le module d'accumulateur d'énergie électrique respectif (M1, M2, M3, M4, M5, M6, M7, M8, M9, M10) aux moyens de raccordement de l'accumulateur d'énergie électrique,
l'unité de commande étant conçue pour évaluer les signaux des capteurs et commander les moyens de commutation.

10. Dispositif, notamment véhicule,
**caractérisé en ce que**
le dispositif comporte un accumulateur d'énergie électrique selon l'une quelconque des revendications 8 ou 9.
